# EUROPÄISCHE PATENTSCHRIFT

(11) **EP 1 231 826 B1**
(45) Veröffentlichungstag und Bekanntmachung des Hinweises auf die Patenterteilung: **16.08.2006**
(21) Anmeldenummer: 02003059.9
(22) Anmeldetag: 12.02.2002
(51) Int. Cl.: H05K 7/14, G06F 1/18

(54) **Vorrichtung zur Befestigung eines Motherboards**
Fastening device for a motherboard
Dispositif pour fixer une carte mère

(30) Priorität: 13.02.2001 DE 10106555
(43) Veröffentlichungstag der Anmeldung: 14.08.2002
(73) Patentinhaber: Fujitsu Siemens Computers GmbH, 80807 München (DE)
(72) Erfinder: Neukam, Wilhelm, 86399 Bobingen (DE)
(74) Vertreter: Epping - Hermann - Fischer

(56) Entgegenhaltungen:
- EP-A- 1 014 771
- DE-U- 29 603 747
- US-A- 5 691 504
- US-A- 5 973 926

## Beschreibung

Die Erfindung betrifft eine Vorrichtung zur Befestigung eines Motherboard an einer Wandung in einem Computer, wobei von dieser Wandung ein hakenförmiger Vorsprung ab steht, welcher beim Einsetzen des Motherboards durch eine entsprechende Öffnung im Motherboard steckbar ist.

Eine derartige Befestigung eines Motherboards an einer Wandung im Computer ist durch das US-Patent US 5973926 A von der Firma Palo Alto bekannt.

Bei dieser Lösung ist es jedoch notwendig, daß das Computergehäuse zumindest zwei im wesentlichen aufeinander senkrecht stehende Wandungen aufweist, wobei von der einen Wandung die hakenförmigen Vorsprünge abstehen und an der anderen Wandung Mittel vorgesehen sind, welche das Motherboard unter die Hinterschneidung der hakenförmigen Vorsprünge zieht.

Diese Lösung hat jedoch zwei Nachteile, zum einen muß das Motherboard immer nahe einer zum Motherboard senkrecht stehenden Wand angeordnet werden, damit die Mittel zum Ziehen des Motherboards gegen diese Wand mit dem Motherboard zusammenwirken können.

Zum anderen ist diese Lösung relativ toleranzempfindlich, da die Mittel zum ziehen des Motherboards gegen die zweite senkrechte Wand meist in Form einer Schraube verwirklicht sind und diese somit exakt in die Gewindeaufnahme des Gegenstückes unterhalb des Motherboards treffen muß. Somit ist es wichtig, daß die hakenförmigen Vorsprünge auf der ersten Wandungsseite exakt auf die Schraube bzw. die Mittel zum Ziehen des Motherboards auf der zweiten Wandungsseite abgestimmt sind.

Aus der Druckschrift EP 1 014 771 A1 ist eine Befestigungsmöglichkeit eines Computermotherboards an einer Wandung eines Computergehäuses bekannt, bei der das Motherboard an hakenförmige Vorsprünge steckbar ist. Die hackenförmigen Vorsprünge stehen von der Wandung ab. Das Computermotherboard ist daran steckbar beziehungsweise hinterschiebbar. Weiter zeigt Druckschrift D1 einen zylinderförmigen Vorsprung der Wandung des Computergehäuses, mittels dem das in die hakenförmigen Vorsprünge eingerastete Motherboard durch eine Öffnung im Motherboard mit einer Schraube befestigt wird. Ein Massekontakt des Computermotherboards mit dem Computergehäuse ist durch die Unterseite der Hakenelemente gebildet, wodurch sich eine sehr kleine Auflagefläche und damit auch eine sehr kleine Kontaktfläche ergeben. Schraubverbindungen bergen den Nachteil in sich, dass zur Bildung einer Schraubverbindung während eines Herstellungsprozesses viel Zeit benötigt wird. Kleine Kontaktflächen bergen den Nachteil in sich, hohe Übergangswiderstände oder Kontaktunterbrechungen zu bilden.

Es ist die Aufgabe der Erfindung, eine Befestigungsmöglichkeit für ein Motherboard in einem Computergehäuse aufzuzeigen, die in der Montage einfach, schnell und damit kostengünstig ist und dabei eine sichere Massenkontaktierung von Motherboard zum Computergehäuse realisiert.

Diese Aufgabe wird erfindungsgemäß dadurch gelöst, daß von der Wandung ein weiterer Vorsprung absteht, der mit einer weiteren Öffnung im Motherboard derart zusammen wirkt, daß nach dem Unterschieben des Motherboards unter den Hinterschnitt des hakenförmigen Vorsprunges ein Klemmstift durch die weitere Öffnung im Motherboard einsteckbar ist.

Das Zusammenwirken des Klemmstiftes mit dem hakenförmigen Vorsprung garantiert somit eine eindeutige Festlegung an nur einer Wandung eines Computers.

Vorzugsweise ist der weitere Vorsprung in die weitere Öffnung im Motherboard einsteckbar, da hierdurch vor dem Einsetzen des Klemmstiftes eine eindeutige Lagezentrierung erreicht wird.

Auch ist es vorteilhaft, zumindest zwei weitere Vorsprünge pro Motherboard vorzusehen, um eine eindeutige Festlegung zu garantieren.

Für die Massekontaktierung ist es günstig, daß die Öffnungen im Motherboard sowie der Bereich um die Öffnungen mit einem Massepad versehen sind.

Für die Massekontaktierung weist die erfindungsgemäße Lösung vorzugsweise an den hakenförmigen Vorsprüngen sowie auch an den weiteren Vorsprüngen Auflagen zur Kontaktierung des Massepads an der Unterseite des Motherboards auf.

Nachfolgend wird die Erfindung anhand eines in den Zeichnungen dargestellten Ausführungsbeispieles näher erläutert.

In den Zeichnungen zeigen:
- Figur 1: eine Schrägansicht eines Motherboards,
- Figur 2: eine isolierte Darstellung eines weiteren Vorsprun-; ges mit einem Teil des Motherboards im Schnitt
- Figur 3: eine isolierte Darstellung des hakenförmigen Vorsprunges mit einem Teil des Motherboards im Schnitt und
- Figur 4: die Ansicht gemäß Figur 3 von oben.

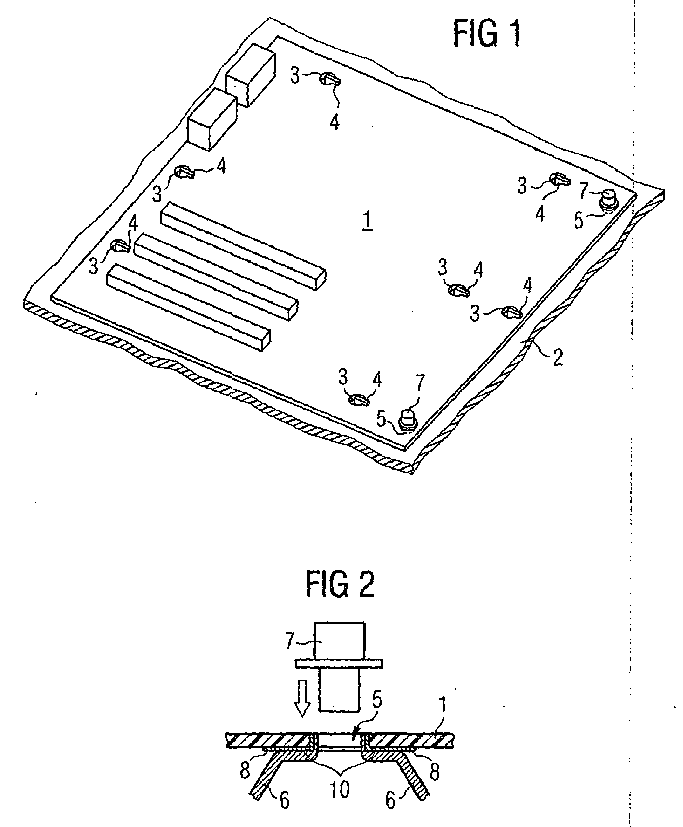

Die Figur 1 zeigt in Schrägansicht schematisiert ein Motherboard 1, wie es auf einer Wandung 2 eines Computers festgelegt ist.

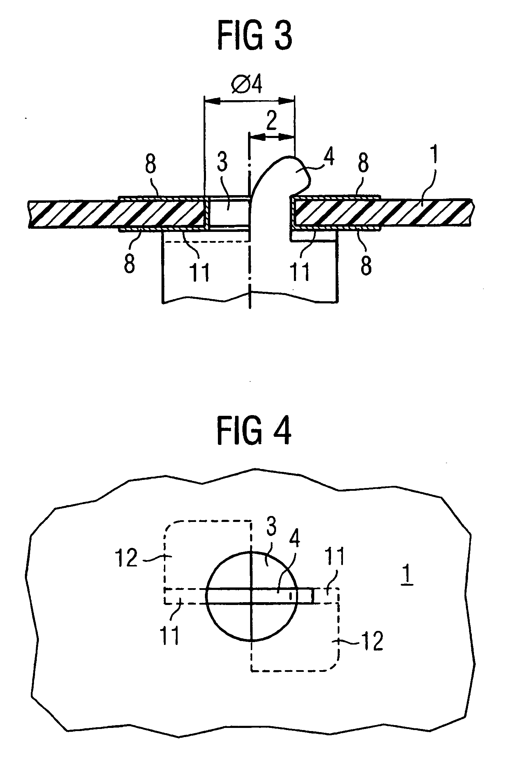

Das Motherboard 1 weist eine Reihe von Öffnungen 3 auf, durch welche hakenförmige Vorsprünge 4 gesteckt sind. Die hakenför-: migen Vorsprünge 4 werden in Figur 3 näher erläutert.

Desweiteren weist das Motherboard 1 weitere Öffnungen 5 auf, welche nach dem Unterschieben des Motherboards 1 jeweils unter die Hinterschneidung der hakenförmigen Vorsprünge 4 mit weiteren Vorsprüngen 6 (siehe Figur 2) zusammenwirken, so daß durch die weiteren Öffnungen 5 ein Klemmstift 7 in die weiteren Vorsprünge 6 einschiebbar ist.

In Figur 2 ist im Schnitt ein weiterer Vorsprung 6 dargestellt, wie er mit einer weiteren Öffnung 5 zusammenwirkt.

Der weitere Vorsprung 6 ist gemäß diesem Ausführungsbeispiel so ausgebildet, daß er mit seinem freien Ende in die weitere Öffnung 5 einfädelt.

Ebenso ist es jedoch auch möglich, daß er nur die UnterseiteI des Motherboards 1 im Bereich der weiteren Öffnung 5 kontaktiert.

Zur Festlegung wird ein Klemmstift 7 in den weiteren Vorsprung 6 eingesteckt.

Die weitere Öffnung 5 ist sowohl innerhalb der Bohrung als auch an der Unterseite mit einem Massepad 8 versehen. Der weitere Vorsprung 6 ist so ausgebildet, daß er einen Absatz 10 aufweist, welcher das Massepad 8 von der Unterseite kontaktiert. Eine weitere Kontaktierung erfolgt durch die freien Enden des weiteren Vorsprunges 6 innerhalb der weiteren Öffnung 5, da diese durch den Klemmstift 7 gegen die Wandungen und somit den Massepad 8 innerhalb der Öffnung 5 gepresst werden.

Figur 3 zeigt wie bereits oben erwähnt das Motherboard 1 im Bereich der Öffnung 3 mit eingesetztem hakenförmigem Vorsprung 4 im Schnitt. Auch die Öffnung 3 ist sowohl innerhalb der Öffnung sowie auch unterhalb und oberhalb mit einem Maissepad 8 versehen. An dem hakenförmigen Vorsprung ist ebenfalls ein Absatz 11 ausgebildet, welcher an der Unterseite das Massepad 8 kontaktiert.

In der Darstellung gemäß Figur 3 ist das Motherboard 1 bereits unter den Hinterschnitt des hakenförmigen Vorsprunges 4 geschoben.

Durch den Hinterschnitt kontaktiert somit der hakenförmige Vorsprung 4 das Massepad 8 sowohl an der Innenseite der Öffnung 3 sowie auch leicht an der Oberseite unterhalb des Hinterschnitts.

Zur besseren Massekontaktierung sind von den Absätzen 11 der orsprünge 4 jeweils seitlich Auflagelappen 12 abgebogen, welche somit eine flächige Massekontaktierung des Massepads erlauben.

Figur 4 zeigt die Ansicht gemäß Figur 3 von oben, wobei hier gestrichelt die Auflagelappen 12 unterhalb des Motherboards 1 dargestellt sind.

Lediglich innerhalb der Öffnung 3 ist ein Teil der Auflagelappen 12 direkt zu sehen.

Bei dem handelsüblichen µATX-Board ist die Öffnung 3 mit einem Durchmesser von 4 mm und der Massepad mit einem Durchmesser von 10 mm dimensioniert. Der hakenförmige Vorsprung 4 weist ca. eine Breite von 2 mm auf, wobei sein oberes Ende soweit seitlich abgebogen ist, daß ein Hinterschnitt von 1 bis 1,5 mm entsteht.

Die erfindungsgemäße Vorrichtung zur Befestigung eines Motherboards an einer Wandung in einem Computer erlaubt somit nur durch das Einsetzen von einer oder zwei Klemmstiften eine sichere Festlegung des Motherboards.

### Bezugszeichenliste

- 1: Motherboard
- 2: Wandung
- 3: Öffnung
- 4: hakenförmiger Vorsprung
- 5: weitere Öffnung
- 6: weiterer Vorsprung
- 7: Klemmstift
- 8: Massepad
- 10: Absatz
- 11: Absatz
- 12: Auflagelappen

## Patentansprüche

1. Computergehäuse mit einer Wandung (2), die zur Befestigung eines Motherboards (1) eingerichtet ist, mit
- einem hakenförmigen Vorsprung (4), der von der Wandung (2) absteht und dafür vorgesehen ist, in eine Öffnung eines Motherboards einzugreifen,
- einem weiteren Vorsprung (6) der von der Wandung (2) absteht,
- einem Massepad (8) womit die Öffnungen (3, 5) im Motherboard (1)sowie der Bereich um die Öffnungen versehen sind,
**dadurch gekennzeichnet, daß**
der weitere Vorsprung (6) dazu eingerichtet ist mit einer weiteren Öffnung (5) im Motherboard (1) derart zusammenzuwirken, daß nach dem Unterschieben des Motherboardes (1) unter den Hinterschnitt des hakenförmigen Vorsprunges (4) ein Klemmstift durch die weitere Öffnung (5) im Motherboard (1) durchführbar und in eine Ausnehmung des weiteren Vorsprungs einsteckbar ist und
dass der hakenförmige Vorsprung (4) Auflagelappen (12) zur flächigen Kontaktierung des Massepads (8) an der Unterseite des Motherboards aufweist.

2. Vorrichtung nach Anspruch 1,
**dadurch gekennzeichnet, daß**
der weitere Vorsprung (6) zur Lagezentrierung in die weitere Öffnung (5) im Motherboard (1) einsteckbar ist.

3. Vorrichtung nach Anspruch 1 oder 2,
**dadurch gekennzeichnet, daß**
zwei weitere Vorsprünge (6) pro Motherboard (1) vorhanden sind.

4. Vorrichtung nach einem der Ansprüche 1 bis 3,
**dadurch gekennzeichnet, daß**
der hakenförmige Vorsprung einen Absatz (11) zur Kontaktierung des Massepads (8) an der Unterseite des Motherboards (1) aufweist.

5. Vorrichtung nach einem der Ansprüche 1 bis 4,
**dadurch gekennzeichnet, daß**
der weitere Vorsprung (6) einen Absatz (10) zur Kontaktierung des Massepads (8) an der Unterseite des Motherboards im Bereich um die Öffnung (5) aufweist.

## Claims

1. Computer chassis having a wall (2), which is disposed for fastening a motherboard (1), having
- a hooked projection (4), which protrudes from the wall (2) and is provided to engage in a hole of a motherboard,
- an additional projection (6), which protrudes from the wall (2),
- a ground pad (8), the holes (3, 5) in the motherboard (1) and the area around the holes being provided therewith:
**characterized in that**
the additional projection (6) is disposed to interact with an additional hole (5) in the motherboard (1) in such a way that after sliding the motherboard (1) under the overhang of the hooked projection (4), a clamping pin can be passed through the additional hole (5) in the motherboard (1) and can be inserted in a recess of the additional projection, and
the hooked projection (4) has contact lobes (12) for making contact with the ground pad (8) over a flat surface on the underside of the motherboard.

2. Device according to Claim 1,
**characterized in that**
the additional projection (6) can be inserted in the additional hole (5) in the motherboard (1) for centring the position.

3. Device according to Claim 1 or 2,
**characterized in that**
there are two additional projections (6) per motherboard (1).

4. Device according to one of the Claims 1 to 3,
**characterized in that**
the hooked projection has a shoulder (11) for making contact with the ground pad (8) on the underside of the motherboard (1).

5. Device according to one of the Claims 1 to 4,
**characterized in that**
the additional projection (6) has a shoulder (10) for making contact with the ground pad (8) on the underside of the motherboard in the area around the hole (5).

## Revendications

1. Châssis d'ordinateur comportant une paroi (2), qui est conçue afin de fixer une carte mère (1), comprenant:
- une protubérance en forme de crochet (4), qui saille de la paroi (2) et est prévue afin de s'engager dans une ouverture d'une carte mère,
- une autre protubérance (6) qui saille de la paroi (2),
- une pastille de masse (8) dont les ouvertures (3,5) dans la carte mère (1) ainsi que la zone entourant les ouvertures sont pourvues,
**caractérisé en ce que**
l'autre protubérance (6) est conçue de manière à coopérer avec une autre ouverture (5) dans la carte mère (1), de telle sorte que, après que la carte mère (1) a été glissée sous la découpe arrière de la protubérance en forme de crochet (4), un goujon de fixation puisse être inséré à travers l'autre ouverture (5) dans la carte mère (1) et enfiché dans un évidement de l'autre protubérance et
**en ce que** la protubérance en forme de crochet (4) présente des lobes de support permettant le contact à plat de la pastille de masse (8) sur le côté inférieur de la carte mère.

2. Dispositif selon la revendication 1,
**caractérisé en ce que**
l'autre protubérance (6) peut être enfichée dans l'autre ouverture (5) dans la carte mère (1) afin d'obtenir un positionnement centré.

3. Dispositif selon la revendication 1 ou 2,
**caractérisé en ce que**
deux protubérances supplémentaires (6) par carte mère (1) sont présentes.

4. Dispositif selon une des revendications 1 à 3,
**caractérisé en ce que**
la protubérance en forme de crochet présente un épaulement (11) pour contacter la pastille de masse (8) sur le côté inférieur de la carte mère (1).

5. Dispositif selon une des revendications 1 à 4,
**caractérisé en ce que**
l'autre protubérance (6) présente un épaulement (10) pour contacter la pastille de masse (8) sur le côté inférieur de la carte mère dans la zone entourant l'ouverture (5).
